# FASCICULE DE BREVET EUROPEEN

(11) **EP 2 259 304 B1**
(45) Date de publication et mention de la délivrance du brevet: **04.05.2016**
(21) Numéro de dépôt: 10164878.0
(22) Date de dépôt: 03.06.2010
(51) Int. Cl.: H01L 21/822, H01L 27/06

(54) **Procédé de formation d'un niveau d'un circuit intégré par intégration tridimensionnelle séquentielle**
Herstellungsverfahren einer Ebene eines dreidimensionalen Bauelements mithilfe einer dreidimensionalen sequenziellen Integration
Manufacturing method of one level of a tridimensional integrated circuit by tridimensional sequential integration

(30) Priorité: 05.06.2009 FR 0953766
(43) Date de publication de la demande: 08.12.2010
(73) Titulaire: STmicroelectronics SA, 92120 Montrouge (FR); STMicroelectronics (Crolles 2) SAS, 38920 Crolles (FR); Commissariat à l'Énergie Atomique et aux Énergies Alternatives, 75015 Paris (FR)
(72) Inventeur: Coudrain, Perceval, 38000, Grenoble (FR); Coronel, Philippe, 38530, Barraux (FR); Buffet, Nicolas, 74500, Evians Les Bains (FR)
(74) Mandataire: de Beaumont, Michel

(56) Documents cités:
- DE-A1-102005 022 306
- US-A1- 2005 255 656
- US-A1- 2006 108 627
- US-A1- 2008 191 312
- US-A1- 2009 020 816
- US-A1- 2010 032 762
- US-B2- 7 378 702
- P. BATUDE, M. VINET, A. POUYDEBASQUE, L. CLAVELIER, C. LEROYER, C. TABONE, B. PREVITALI, L. SANCHEZ, L. BAUD, A. ROMAN, V. CARRON: "Enabling 3D monolithic integration" ECS TRANSACTIONS, vol. 16, no. 8, 12 octobre 2008 (2008-10-12), - 17 octobre 2008 (2008-10-17) pages 47-54, XP002553398
- BATUDE P ET AL: "3D CMOS integration: Introduction of dynamic coupling and application to compact and robust 4T SRAM" INTEGRATED CIRCUIT DESIGN AND TECHNOLOGY AND TUTORIAL, 2008. ICICDT 2008. IEEE INTERNATIONAL CONFERENCE ON, IEEE, PISCATAWAY, NJ, USA, 2 juin 2008 (2008-06-02), pages 281-284, XP031287555 ISBN: 9781424418107
- PERCEVAL COUDRAIN ET AL: "Setting up 3D sequential integration for back-illuminated CMOS image sensors with highly miniaturized pixels with low temperature fully depleted SOI transistors" IEEE INTERNATIONAL ELECTRON DEVICES MEETING, IEDM 2008, 15-17 DEC. 2008, SAN FRANCISCO, CO, USA, IEEE, PISCATAWAY, NJ, USA, 15 décembre 2008 (2008-12-15), pages 1-4, XP031434426 ISBN: 9781424423774

## Description

### Domaine de l'invention

La présente invention concerne un procédé de formation, par intégration tridimensionnelle séquentielle, d'un niveau d'un circuit intégré sur un niveau existant.

### Exposé de l'art antérieur

Actuellement, dans le domaine des circuits intégrés, une des solutions connues pour réaliser des systèmes de plus en plus compacts est de réaliser une intégration en trois dimensions. Cette intégration consiste à former plusieurs substrat semiconducteurs, sur et dans lesquels sont formés des composants électroniques, les uns au-dessus des autres, et à connecter des composants de différents niveaux entre eux, par exemple au travers des substrats. Ce type d'intégration permet d'augmenter la densité d'intégration et le nombre de fonctionnalités intégrées. Ce type d'intégration permet aussi de minimiser la longueur des interconnexions entre les différents éléments des circuits électroniques et de réduire la consommation.

On connaît des procédés dit d'intégration séquentielle dans lesquels l'architecture tridimensionnelle est réalisée niveau après niveau, dans un enchaînement vertical. Des composants sont formés dans et sur un premier substrat, puis un deuxième substrat est soit fixé au-dessus du premier substrat, soit formé par recristallisation de silicium amorphe ou polycristallin. Dans ce dernier cas, il n'est pas possible d'obtenir un substrat strictement monocristallin. Des composants sont ensuite formés dans et sur le deuxième substrat, etc.

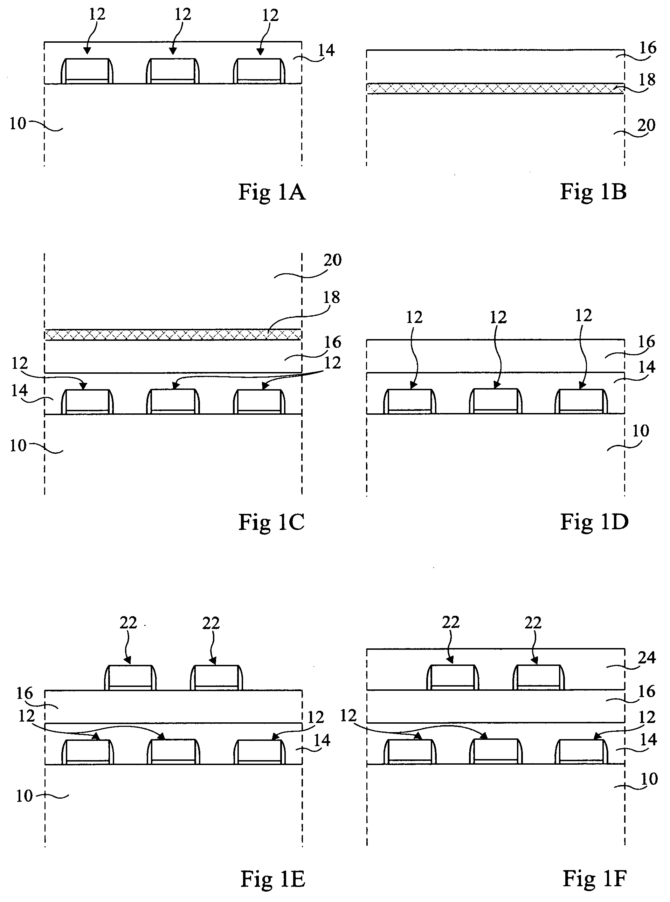

Les figures 1A à 1F illustrent des étapes d'un procédé de formation d'un niveau d'un circuit intégré tridimensionnel par intégration séquentielle. Ce procédé est notamment décrit dans la publication intitulée "65nm High Performance SRAM Technology with 25F2, 0.16um2 S3 (Stacked Single-crystal Si) SRAM Cell, and Stacked Peripheral SSTFT for Ultra High Density and High Speed Applications", de H. Lim et al., Proceedings of ESSDERC, 2005.

La figure 1A illustre un niveau d'un circuit intégré tridimensionnel et la figure 1B illustre une structure à partir de laquelle on forme un niveau supérieur du circuit intégré, par intégration séquentielle.

La figure 1A représente un substrat 10 sur et dans lequel sont formés des composants électroniques. Dans l'exemple représenté, des grilles de transistors 12 sont formées en surface du substrat 10. Bien entendu, d'autres composants électroniques peuvent être formés dans et sur le substrat 10. Sur les composants 12 est formé un empilement 14 de matériau diélectrique dans lequel des éléments d'interconnexion (pistes et vias conducteurs) peuvent être prévus. Dans la suite de la description, les empilements tels que l'empilement 14 seront appelés "empilement d'interconnexion", bien que les pistes et vias métalliques dans ces empilements soient optionnels.

La figure 1B représente une structure comprenant un substrat de silicium monocristallin 16 formé sur une couche isolante 18, elle-même s'étendant sur un support 20, par exemple un support semiconducteur. La structure de la figure 1B peut être formée par tout procédé connu sous l'appellation SOI (silicium sur isolant).

A l'étape illustrée en figure 1C, la face libre du substrat de silicium 16 a été collée, par tout moyen connu, par exemple par adhésion moléculaire, en surface de l'empilement d'interconnexion 14 de la structure représentée en figure 1A.

A l'étape illustrée en figure 1D, le support semiconducteur 20 et la couche isolante 18 ont été éliminés. On obtient ainsi une structure dans laquelle, sur l'empilement d'interconnexion 14, s'étend un second substrat de silicium 16.

A l'étape illustrée en figure 1E, des composants électroniques, par exemple des transistors 22 à grilles isolées, sont formés dans et sur le substrat de silicium 16.

A l'étape illustrée en figure 1F, un deuxième empilement d'interconnexion 24 est formé sur les composants électroniques 22. L'empilement 24 peut comprendre des éléments d'interconnexion (pistes et vias conducteurs) et peut être connecté électriquement à une métallisation de l'empilement 14 ou directement aux transistors 12 si aucun élément d'interconnexion n'est formé dans l'empilement 14. On obtient ainsi une structure au-dessus de laquelle peuvent être formés d'autres substrats, et ainsi d'autres niveaux du circuit intégré tridimensionnel, en procédant de la même façon que pour la formation du substrat de silicium 16.

Dans ce procédé, les composants formés sur et dans le substrat 16 sont formés lors d'étapes indépendantes des étapes de formation du substrat 16. Notamment, la formation d'un isolant de grille en oxyde de silicium pour les transistors 22 implique divers types de dépôts chimiques en phase vapeur (par exemple PECVD, pour Plasma Enhanced Chemical Vapor Deposition, HDP-CVD, pour High-Density Plasma Chemical Vapor Deposition, ALD, pour Atomic Layer Deposition, ou encore SACVD, pour Sub-Atmospheric Chemical Vapor Deposition). Ces procédés ne permettent généralement pas d'obtenir des couches dont l'épaisseur est définie avec une précision meilleure que 5 nm. Par ailleurs, pour l'ensemble de ces procédés, un inconvénient majeur est de former un oxyde présentant une interface avec le silicium de qualité moyenne, du moins de moins bonne qualité que les oxydes dits "thermiques" formés par oxydation thermique de la surface du silicium. Ceci est dû à la présence de pièges dans l'oxyde formé par dépôt et de liaisons pendantes à l'interface entre le silicium et l'oxyde, ce qui n'est pas le cas des couches d'oxyde obtenues par le biais d'une réaction d'oxydation (oxyde thermique).

Les procédés de formation de couches d'oxyde thermique nécessitent des étapes de chauffage du silicium à des températures élevées, généralement de l'ordre de 1000°C, ce qui rend ces procédés incompatibles avec des procédés de formation de dispositifs tridimensionnels, des composants électroniques étant présents dans des niveaux inférieurs du dispositif. En effet, des températures trop élevées détruisent les caractéristiques de composants tels que les transistors. Des températures compatibles avec ces composants, typiquement inférieures à 700°C, ne permettent pas, quant à elles, des cinétiques d'oxydation suffisantes.

La publication intitulée "Enabling 3D Monolithic Integration", de P. Batude et al., ECS Transactions, 16(8) 47-54 (2008) décrit un procédé de fabrication d'un circuit intégré tridimensionnel comprenant une étape de collage d'un substrat SOI sur le premier niveau de composants, une étape de suppression du second support semiconducteur et une étape de formation de l'oxyde de grille des composants du niveau supérieur par dépôt d'une couche d'HfO₂.

Les publications "3D CMOS Integration : Introduction of Dynamic coupling and Application to compact and Robust 4T SRAM", de D. Batude et al., ICICDT 2008, p. 281-284 et "Setting up 3D Sequential Integration for Back-Illuminated CMOS Image Sensors with Highly Miniaturized Pixels with low temperature Fully Depleted SOI transistors", de P. Condrain et al., IEDM 2008, p. 1-4, dévoilent toutes deux un procédé de fabrication d'un circuit intégré tridimmensionnel où l'oxyde de grille des composants du niveau supérieur est formé par dépôt d'une couche d'HfO₂. Dans les trois publications mentionnées ci-dessus (de P. Batude et al., P. Batude et al. et P. Condrain et al.), l'oxyde de grille des composants du niveau supérieur est formé par dépôt d'une couche d'HfO₂ à basse température, c'est-à-dire autour de 600-700°C, afin de ne pas emdommager les composants déjà formés du niveau inférieur. La qualité d'un oxyde déposé à basse température est en revanche moindre que celle d'un oxyde thermique formé à haute température.

Ainsi, il existe un besoin d'un procédé de fabrication d'un circuit intégré tridimensionnel par intégration séquentielle dans lequel, dans des niveaux supérieurs du circuit, les oxydes de grille sont de bonne qualité.

### Résumé

Un objet d'un mode de réalisation de la présente invention est de prévoir un procédé de fabrication, par intégration séquentielle, d'un niveau d'une structure tridimensionnelle, des grilles isolées formées sur ce niveau étant isolées par un oxyde thermique.

Ainsi, un mode de réalisation de la présente invention prévoit un procédé de formation d'un niveau d'une structure tridimensionnelle sur un premier support dans lequel sont formés des composants, comprenant les étapes suivantes :
former, sur un deuxième support semiconducteur, un substrat semiconducteur monocristallin avec interposition d'une couche d'oxyde thermique ;
apposer la face libre du substrat semiconducteur monocristallin sur la surface supérieure du premier support ;
éliminer le deuxième support semiconducteur ; et
amincir la couche d'oxyde thermique jusqu'à une épaisseur propre à constituer un isolant de grille.

Selon un mode de réalisation de la présente invention, l'amincissement de la couche d'oxyde thermique est réalisé à l'aide d'un faisceau ionique à base d'amas d'atomes.

Selon un mode de réalisation de la présente invention, l'amincissement de la couche d'oxyde thermique est réalisé à l'aide d'un faisceau ionique à base de monomères.

Selon un mode de réalisation de la présente invention, la face libre du substrat de silicium monocristallin est fixée au premier support par adhésion moléculaire.

Selon un mode de réalisation de la présente invention, le procédé comprend en outre les étapes de formation, sur la couche d'oxyde thermique amincie, d'une couche conductrice, et de gravure de la couche conductrice et la couche d'oxyde thermique de façon à former des grilles isolées.

Selon un mode de réalisation de la présente invention, le deuxième support est éliminé par une combinaison d'un polissage mécano-chimique et d'une gravure humide.

Selon un mode de réalisation de la présente invention, la couche d'oxyde thermique fait partie d'un empilement diélectrique multicouches tel qu'un empilement oxyde-nitrure-oxyde.

Selon un mode de réalisation de la présente invention, le substrat semiconducteur monocristallin est en silicium.

Un mode de réalisation ne faisant pas partie de la présente invention prévoit en outre un circuit à intégration tridimensionnelle, comprenant des substrats semiconducteurs situés les uns au-dessus des autres et séparés par des empilements d'interconnexion, des grilles isolées étant formées sur au moins certains des substrats, les régions isolantes des grilles étant en un oxyde thermique.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A à 1F, précédemment décrites, illustrent un procédé connu de formation d'un niveau d'un circuit intégré tridimensionnel par intégration séquentielle ; et
les figures 2A à 2F illustrent un procédé de formation d'un niveau d'un circuit intégré tridimensionnel selon un mode de réalisation de la présente invention.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

Pour obtenir, par intégration séquentielle, un circuit intégré tridimensionnel comprenant, sur un niveau supérieur, des grilles isolées dont le diélectrique est un oxyde obtenu par une réaction d'oxydation thermique, les inventeurs prévoient un procédé permettant de tirer profit de la couche d'oxyde thermique présente, au-dessus du substrat du niveau supérieur, lors du collage de celui-ci sur un niveau existant.

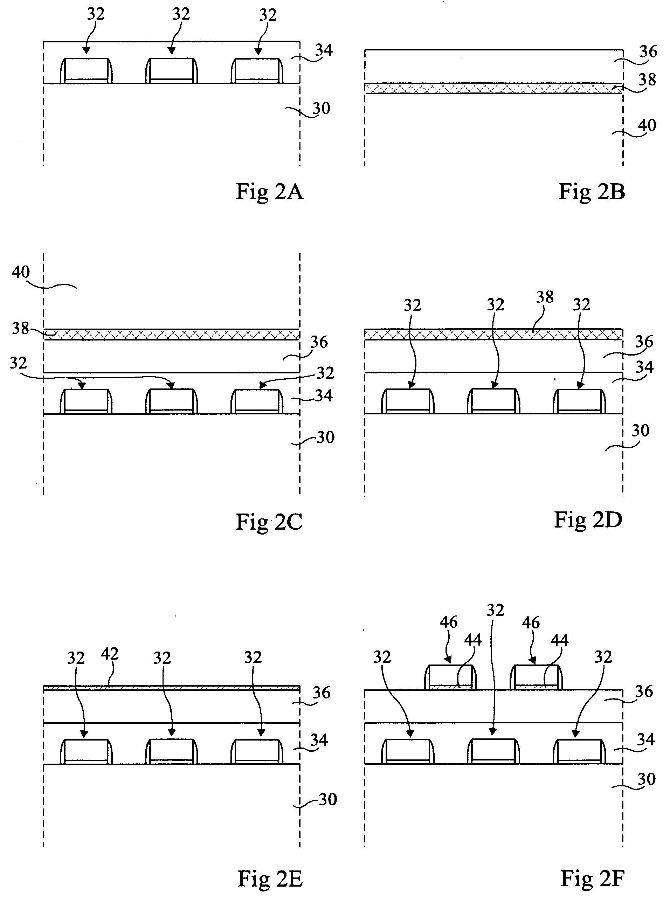

Les figures 2A à 2F illustrent des résultats d'étapes d'un tel procédé. La figure 2A illustre un support comprenant des composants électroniques formant un niveau inférieur du circuit intégré et la figure 2B illustre une structure à partir de laquelle on forme un niveau supplémentaire du circuit intégré.

La figure 2A représente un substrat 30 sur lequel sont formés des composants électroniques 32, par exemple des transistors à grilles isolées. Sur les composants 32 s'étend un empilement d'interconnexion 34 dans lequel peuvent être formées des pistes et vias conducteurs, séparés par un matériau diélectrique, pour permettre des connexions entre les composants 32 et des connexions avec des composants du niveau supérieur. On notera que le substrat 30 pourrait lui-même constituer un niveau supérieur d'un empilement de niveaux d'un circuit tridimensionnel.

La figure 2B illustre une structure comprenant un substrat de silicium 36 formé sur une couche d'oxyde 38 s'étendant elle-même sur un support 40. La couche d'oxyde 38 est, de façon classique, une couche d'oxyde thermique, par exemple en oxyde de silicium, en oxynitrure de silicium ou en tout autre oxyde thermique formé à température élevée.

L'empilement de la figure 2B constitue une structure courante de silicium sur isolant, dite SOI. Pour obtenir une telle structure, on pourra par exemple former, en surface de deux tranches de silicium indépendantes, une couche d'oxyde thermique par oxydation à haute température (supérieure à 1000°C) du silicium. Les deux couches d'oxyde thermique ainsi formées sont ensuite mises en contact, et le substrat supérieur (correspondant au substrat de silicium 36) est ensuite aminci pour obtenir un substrat d'épaisseur désirée.

A l'étape illustrée en figure 2C, la face supérieure libre du substrat de silicium 36 a été reportée sur l'empilement d'interconnexion 34. Le substrat de silicium 36 et l'empilement d'interconnexion 34 peuvent être "collés", par exemple par adhésion moléculaire (encore appelée "collage direct"). Pour cela, un polissage de la face supérieure de l'empilement d'interconnexion 34 et de la face supérieure du substrat 36 pourra être réalisé, de même qu'une préparation chimique des surfaces pour promouvoir le collage. Après la mise en contact des deux éléments, des liaisons de faible énergie se créent entre les deux surfaces par les forces de Van der Waals ou des ponts hydrogènes. Ces liaisons sont ensuite transformées en liaisons de plus forte énergie, permettant un collage permanent, en réalisant un recuit de consolidation, dont la température conditionne en partie l'énergie d'adhésion finale. Pour ne pas dégrader les composants électroniques 32 formés dans et sur le substrat 30 (et dans des niveaux inférieurs le cas échéant), le chauffage est réalisé à une température typiquement inférieure à 600°C. Avantageusement, un tel chauffage permet d'obtenir une énergie de liaison importante (typiquement supérieure à 900 mJ/m²) entre les couches 34 et 36.

A l'étape illustrée en figure 2D, le support semiconducteur 40 a été éliminé. A titre d'exemple, le support 40 peut être éliminé par une combinaison d'une gravure humide et d'un polissage mécano-chimique, l'arrêt de la gravure se faisant sur la couche d'oxyde thermique 38 grâce à un procédé de gravure du semiconducteur sélectif vis-à-vis de l'oxyde de silicium.

A l'étape illustrée en figure 2E, la couche d'oxyde thermique 38, qui a une épaisseur initiale supérieure à 20 nm (généralement de l'ordre de 150 nm) a été amincie pour former une couche d'oxyde thermique 42 ayant une épaisseur comprise entre 3 et 15 nm, adaptée à former une couche de diélectrique de grille.

Les procédés courants de gravure chimique et d'attaque plasma ne sont pas assez précis dans leurs états actuels pour amincir la couche 38. Ainsi, pour réaliser l'amincissement, les inventeurs prévoient de réaliser une gravure de la couche d'oxyde 38 en faisant intervenir un faisceau ionique. Cette gravure pourra être une gravure à l'aide d'un faisceau ionique à base d'amas d'atomes (plusieurs milliers d'atomes pour une à deux charges) ou à l'aide d'un faisceau ionique à base de monomères (une charge par atome).

Pour cela, une cartographie initiale de la surface de la couche d'oxyde thermique 38 est réalisée, puis on bombarde localement cette surface. On élimine ainsi plus ou moins de matière en fonction du temps de résidence du faisceau localement devant chaque point de la surface de la couche 38. Avantageusement, les gravures par faisceaux ioniques à base d'amas d'atomes sont capables d'un excellent contrôle de l'épaisseur de la couche abrasée, permettant d'obtenir une couche d'oxyde thermique 42 ayant une épaisseur de l'ordre de 6 nm, avec une variation d'épaisseur inférieure à un nanomètre. Bien entendu, tout procédé qui pourra être développé pour réaliser un tel amincissement pourra être utilisé.

On notera qu'une seconde étape de cartographie de la surface de la couche d'oxyde thermique pourra être réalisée lors d'une étape intermédiaire, pour ajuster l'épaisseur d'oxyde à éliminer en chaque point de la couche d'oxyde 38.

A l'étape illustrée en figure 2F, la couche d'oxyde thermique 42 a été gravée, en des emplacements désirés, pour former des portions 44 formant les diélectriques de grilles de transistors isolés 46 formés sur le substrat 36. Pour former les grilles des transistors 46, on pourra former, sur la structure de la figure 2E, une couche pleine plaque de silicium polycristallin ou de matériau conducteur propre à constituer le conducteur des grilles puis graver la couche de matériau conducteur et la couche d'oxyde 42 à l'aide d'un unique masque.

Les transistors 46 ainsi formés ont l'avantage d'avoir une région de diélectrique de grille en un oxyde thermique, dont l'interface avec le silicium monocristallin du substrat 36 est quasi parfaite. Ainsi, on diminue fortement la dispersion entre les différents composants électroniques, on préserve une mobilité élevée des porteurs dans la région du canal des transistors et un niveau de bruit basse fréquence réduit grâce à une densité de défauts plus faible à l'interface (ou à proximité de l'interface) entre l'oxyde et le silicium. On notera que la couche d'oxyde thermique 42 pourra également être utilisée pour la formation de tout composant nécessitant une couche isolante en surface du substrat 36, par exemple des mémoires.

On comprendra que les étapes des figures 2A à 2F pourront être répétées plusieurs fois pour former des circuits intégrés tridimensionnels comprenant plus de deux niveaux.

Des modes de réalisation particuliers de la présente invention ont été décrits. Diverses variantes et modifications apparaîtront à l'homme de l'art. En particulier, on notera que la couche d'oxyde thermique 42 pourra être en tout matériau isolant dont la fabrication implique des températures élevées.

De plus, dans la description qui précède, on a parlé de l'utilisation d'un oxyde thermique formé dans une structure SOI pour former des isolants de grille d'un niveau d'un circuit tridimensionnel. On notera que l'on pourrait également former une structure de type SOI dans laquelle la couche de matériau diélectrique intermédiaire est constituée d'un empilement de matériaux diélectriques formés par des procédés thermiques, par exemple un empilement oxyde-nitrure-oxyde thermique. Dans ce cas, l'empilement pourra être prévu pour former des isolants de grille dans des niveaux d'un circuit tridimensionnel, par exemple pour des composants formant mémoire.

De plus, la présente description a été faite dans le cas où le substrat 36 est un substrat de silicium, et où la couche d'oxyde thermique 38 est en oxyde de silicium. On notera que le substrat 36 pourra également être en tout matériau semiconducteur monocristallin, par exemple en silicium-germanium ou en germanium, sur lequel est susceptible d'être formé un oxyde thermique.

## Revendications

1. Procédé de formation d'un niveau d'une structure tridimensionnelle sur un premier support (30, 34) dans lequel sont formés des composants, comprenant les étapes suivantes :
former, sur un deuxième support semiconducteur (40), un substrat semiconducteur monocristallin (36) avec interposition d'une couche d'oxyde thermique (38) ;
apposer la face libre du substrat semiconducteur monocristallin sur la surface supérieure du premier support ;
éliminer le deuxième support semiconducteur ;
ledit procédé étant **caractérisé par** l'étape suivante :
amincir la couche d'oxyde thermique (38) jusqu'à une épaisseur propre à constituer un isolant de grille (42).

2. Procédé selon la revendication 1, dans lequel l'amincissement de la couche d'oxyde thermique est réalisé à l'aide d'un faisceau ionique à base d'amas d'atomes.

3. Procédé selon la revendication 1, dans lequel l'amincissement de la couche d'oxyde thermique est réalisé à l'aide d'un faisceau ionique à base de monomères.

4. Procédé selon l'une quelconque des revendications 1 à 3, dans lequel la face libre du substrat semiconducteur monocristallin (36) est fixée au premier support par adhésion moléculaire.

5. Procédé selon l'une quelconque des revendications 1 à 4, comprenant en outre les étapes suivantes :
former, sur la couche d'oxyde thermique amincie (42), une couche conductrice ; et
graver la couche conductrice et la couche d'oxyde thermique de façon à former des grilles isolées (46).

6. Procédé selon l'une quelconque des revendications 1 à 5, dans lequel le deuxième support (40) est éliminé par une combinaison d'un polissage mécano-chimique et d'une gravure humide.

7. Procédé selon l'une quelconque des revendications 1 à 6, dans lequel la couche d'oxyde thermique fait partie d'un empilement diélectrique multicouches tel qu'un empilement oxyde-nitrure-oxyde.

8. Procédé selon l'une quelconque des revendications 1 à 7, dans lequel le substrat semiconducteur monocristallin (36) est en silicium.

## Patentansprüche

1. Ein Verfahren zum Formen eines Niveaus einer dreidimensionalen Struktur auf einem ersten Träger (30, 34) in dem Komponenten geformt sind, wobei das Verfahren die folgenden Schritte aufweist:
Formen auf einem zweiten Halbleiterträger (40), ein Einkristallhalbleitersubstrat (36) mit einer dazwischen angeordneten thermischen Oxidschicht (38);
Platzieren der freien Oberfläche des Einkristallhalbleitersubstrats auf der oberen Oberfläche des ersten Trägers;
Eliminieren des zweiten Halbleiterträgers; wobei das Verfahren durch den folgenden Schritt gekennzeichnet ist:
Dünner machen der thermischen Oxidschicht (38) hinab bis zu einer Decke die geeignet ist zur Bildung eines Gate Isolators (42).

2. Das Verfahren nach Anspruch 1, wobei die thermische Oxidschicht mittels eines lonenstrahls basierend auf Atomclustern dünner gemacht wird.

3. Das Verfahren nach Anspruch 1, wobei die thermische Oxidschicht mittels eines lonenstrahls basierend auf Monomeren dünner gemacht wird.

4. Das Verfahren nach einem der Ansprüche 1 bis 3, wobei die freie Oberfläche des Einkristallsiliziumsubstrats (36) durch Molekularbindung mit dem ersten Träger verbunden ist.

5. Das Verfahren nach einem der Ansprüche 1 bis 4, wobei ferner die folgenden Schritte vorgesehen sind:
Formen einer leitenden Schicht auf der dünner gemachten thermischen Oxidschicht (42); und
Ätzen der leitenden Schicht und der thermischen Oxidschicht zur Bildung isolierter Gates (46).

6. Das Verfahren nach einem der Ansprüche 1 bis 5, wobei der zweite Träger (40) eliminiert wird und zwar durch eine Kombination chemischmechanischen Polierens und einer Nassätzens.

7. Das Verfahren nach einem der Ansprüche 1 bis 6, wobei die thermische Oxidschicht zu einem dielektrischen Mehrschichtstapel wie beispielsweise einem Oxid-Nitrid-Oxid-Stapel gehört.

8. Das Verfahren nach einem der Ansprüche 1 bis 7, wobei das Einkristallhalbleitersubstrat (36) aus Silizium hergestellt ist.

## Claims

1. A method for forming a level of a tridimensional structure on a first support (30, 34) in which components are formed, comprising the steps of:
forming, on a second semiconductor support (40), a single-crystal semiconductor substrate (36) with an interposed thermal oxide layer (38);
placing the free surface of the single-crystal semiconductor substrate on the upper surface of the first support;
eliminating the second semiconductor support; said method being **characterized by** the following step:
thinning the thermal oxide layer (38) down to a thickness adapted to forming a gate insulator (42).

2. The method of claim 1, wherein the thermal oxide layer is thinned down by means of an ion beam based on atomic clusters.

3. The method of claim 1, wherein the thermal oxide layer is thinned down by means of an ion beam based on monomers.

4. The method of any of claims 1 to 3, wherein the free surface of the single-crystal silicon substrate (36) is bonded to the first support by molecular bonding.

5. The method of any of claims 1 to 4, further comprising the steps of:
forming, on the thinned down thermal oxide layer (42), a conductive layer; and
etching the conductive layer and the thermal oxide layer to form insulated gates (46).

6. The method of any of claims 1 to 5, wherein the second support (40) is eliminated by a combination of a chemical-mechanical polishing and of a wet etch.

7. The method of any of claims 1 to 6, wherein the thermal oxide layer belongs to a dielectric multiple-layer stack such as an oxide-nitride-oxide stack.

8. The method of any of claims 1 to 7, wherein the single-crystal semiconductor substrate (36) is made of silicon.
